# EUROPEAN PATENT APPLICATION

(11) **EP 4 318 831 A1**
(43) Date of publication of application: **07.02.2024**
(21) Application number: 21934637.6
(22) Date of filing: 06.12.2021
(51) Int. Cl.: H01S 5/042, H01S 5/00, H01S 5/183, H01S 5/42, G01S 7/48, G01S 7/481

(54) **LASER AND LASER RADAR COMPRISING SAME**

(30) Priority: 01.04.2021 CN 202110357077
(71) Applicant: Hesai Technology Co., Ltd., Shanghai 201821 (CN)
(72) Inventor: LI, Wei, Shanghai 201821 (CN); CHEN, Jie, Shanghai 201821 (CN); XIAO, Yong, Shanghai 201821 (CN); XIANG, Shaoqing, Shanghai 201821 (CN)
(74) Representative: Appelt, Christian W.
(86) International application number: PCT/CN2021/135749
(87) International publication number: WO 2022/206001

(57) **Abstract**

Provided in the present disclosure is a laser for use in a LiDAR, the laser comprising: a plurality of light-emitting units, each light-emitting unit comprising a plurality of light-emitting points, wherein the plurality of light-emitting units share a cathode or an anode; and each light-emitting unit is respectively provided with a wiring unit; and each wiring unit is electrically connected to an unshared anode or cathode of its corresponding light-emitting unit. The area of a laser provided with a plurality of light-emitting units does not increase, and echo light beams generated from detection light beams emitted by the plurality of light-emitting units are received by the same detector, thereby improving the vertical angular resolution and point cloud density of a LiDAR.

## Description

### TECHNICAL FIELD

The present disclosure relates to the field of laser detection, especially to a laser applicable to a LiDAR, and a LiDAR comprising the laser.

### BACKGROUND ART

In existing LiDARs, the ratio of light-emitting units to detectors is 1:1, with each light-emitting unit corresponding to one detector. Since the current growing demand for a higher vertical angular resolution in a LiDAR, there is the need to enhance the density of the light-emitting units. Due to the limited area of the printed circuit board at the emitting end and the fixed size of components such as capacitors and switches, the aforementioned solution is restricted by the areas of these devices, making it difficult to increase the density of the light-emitting units within the limited area of the printed circuit board. As a result, enhancing the vertical angular resolution of the LiDAR is challenging.

A Vertical Cavity Surface Emitting Laser (VCSEL) comprises a plurality of cavities, with each cavity forming one light-emitting point, and a plurality of light-emitting points form an area array. Since VCSELs are more efficient, have a narrower bandwidth and less temperature drift, it can emit lower power to achieve the same ranging capability, and this is quite beneficial for human eye safety as well.

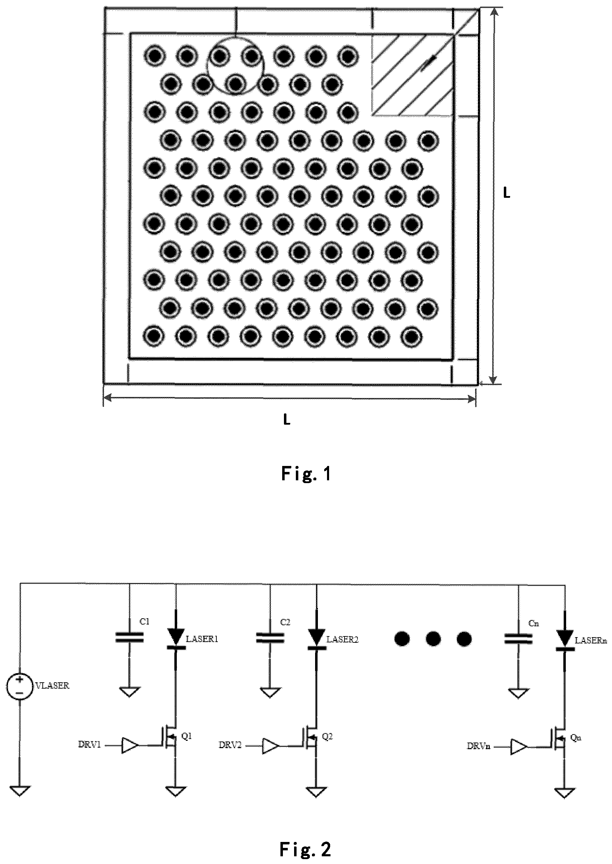

A typical VCSEL design, as shown in FIG. 1, has an area of L*L, comprising a light-emitting region (shown as the region covered by solid dots in the figure) and a wire-bonding region (shown as the slashed region in the figure), where each solid dot corresponds to one light-emitting point, and the wire-bonding region is used for electrical connection to a driving voltage.

The substrate of the VCSEL is made of GaAs, and a conventional solution is to have an N-pole (cathode) at the bottom and the P-poles (anodes) connected to a circuit board through an interconnecting metal layer by wire-bonding at the top. A plurality of VCSELs on the same DIE share an N-pole. For a LiDAR, each light-emitting unit needs to be addressable in order to achieve sequential light emission. Even when simultaneous light emission is required, a relatively large angular difference should be maintained as far as possible to minimize the optical crosstalk. A typical laser driving circuit, as shown in FIG. 2, employs a common-anode configuration to drive lasers LASER1, LASER2... LASERn, and all the anodes of the lasers share a VLASER power supply. The cathode of each laser (LASER1-LASERn) is separately connected to a switching device (Q1-Qn) and a switching driver (DRV1-DRVn). The switching device can be made of GaN, and DRV1-DRVn are GaNdrivers. The light emission of a laser is controlled by the gating of a switching device. Each laser is equipped with one discharge capacitor (C1 ... Cn as shown in FIG. 2), and one power supply switch (not shown) is provided for each laser and its corresponding discharge capacitor to charge the discharge capacitor. When the power supply switch is closed, the power supply VLASER charges the capacitor C. After a period of time, the power supply switch is opened (preventing charging and disconnecting the charging circuit of the capacitor C). Following a sufficient driving signal of the GaN switch to switch on the GaN switch, a discharge loop is formed among the capacitor C, the laser LASER 1, the GaN switch and the ground, causing the laser LASER 1 to emit light. For the driving circuit with such a structure, it is necessary to provide each laser with one separate GaN switch, resulting in a complex circuit structure and higher costs.

The content in the Background Art merely involves the techniques known by the discloser and does not necessarily represent the prior art in the field.

### SUMMARY

In view of at least one drawback in the prior art, the present disclosure provides a laser for use in a LiDAR, comprising: a plurality of light-emitting units, each light-emitting unit comprising a plurality of light-emitting points, wherein the plurality of light-emitting units share a cathode or an anode, each light-emitting unit is respectively provided with a wiring unit, and each wiring unit is electrically connected to an unshared anode or cathode of its corresponding light-emitting unit. With the embodiments of the present disclosure, the laser comprises a plurality of light-emitting units, while the area of the laser does not increase. When the laser is applied in a LiDAR, the echo light beams generated from detection light beams emitted by the plurality of light-emitting units are received by the same detector, thereby improving the vertical angular resolution and point cloud density of the LiDAR.

According to an aspect of the present disclosure, unshared anodes or cathodes of the plurality of light-emitting units are separated by an insulation layer, and shared cathodes or anodes are connected by a first metal layer.

According to an aspect of the present disclosure, the plurality of light-emitting units are configured to be driven to emit light simultaneously or successively.

According to an aspect of the present disclosure, the wiring units of the plurality of light-emitting units are connected to different voltage sources when the plurality of light-emitting units are driven to emit light successively.

According to an aspect of the present disclosure, the wiring units of the plurality of light-emitting units are connected to the same voltage source or different voltage sources when the plurality of light-emitting units are driven to emit light simultaneously.

According to an aspect of the present disclosure, the laser comprises two light-emitting units sharing a cathode, and each light-emitting unit comprising one wiring unit.

According to an aspect of the present disclosure, each light-emitting unit further comprises a second metal layer covering the unshared anodes or cathodes of the light-emitting units, and provided with an opening for light emission of each light-emitting point.

According to an aspect of the present disclosure, the wiring unit is a portion of the second metal layer, or a wiring pad disposed on the second metal layer.

The present disclosure also provides a LiDAR, comprising:
an emitting unit, comprising a plurality of lasers described above, wherein each laser comprises a plurality of light-emitting units configured to emit detection light beams, each light-emitting unit comprising a plurality of light-emitting points, wherein the plurality of light-emitting units share a cathode or an anode, and each light-emitting unit is respectively provided with a wiring unit, and each wiring unit is electrically connected to an unshared anode or cathode of its corresponding light-emitting unit; and
a receiving unit, comprising a plurality of detectors configured to receive echo light beams of the detection light beams after being reflected off an object, and to convert the echo light beams into electrical signals.

According to an aspect of the present disclosure, the emitting unit and the receiving unit of the LiDAR form a plurality of detection channels, each detection channel comprising one light-emitting unit and one corresponding detector.

According to an aspect of the present disclosure, echo light beams generated from detection light beams emitted by the plurality of light-emitting units of the same laser are received by the same detector.

According to an aspect of the present disclosure, the plurality of lasers are arranged in multiple columns along a vertical direction, the multiple columns of lasers being staggered from each other, such that principal light directions of the detection light beams emitted by each light-emitting unit in the plurality of lasers are staggered from each other.

According to an aspect of the present disclosure, the multiple columns of lasers are overall staggered from each other along the vertical direction, or only a middle portion of each column of lasers staggered from each other.

According to an aspect of the present disclosure, a vertical angular resolution of the LiDAR is less than 0.4°.

According to an aspect of the present disclosure, the emitting unit further comprises a driving circuit configured to provide different driving voltages to the plurality of light-emitting units of the lasers.

According to an aspect of the present disclosure, the emitting unit further comprises a switching device comprising a first terminal electrically connected to a shared cathode or anode of the light-emitting units, a second terminal being grounded, and a control terminal that can control the ON and OFF of the switching device according to a driving signal.

According to an aspect of the present disclosure, the emitting unit is configured to drive each light-emitting unit in sequence to emit detection light beams.

A LiDAR according to an embodiment of the present disclosure comprises a laser provided with a plurality of light-emitting units. The area of the laser provided with a plurality of light-emitting units does not increase, and echo light beams generated from detection light beams emitted by the plurality of light-emitting units are received by the same detector, hereby improving the vertical angular resolution and point cloud density of the LiDAR. Meanwhile, the number of light-emitting units is doubled in the same area, allowing the plurality of light-emitting units driven by different driving voltages in a driving circuit to share a switching device, thereby saving the switching devices and the driving thereof, reducing the costs, and realizing an emitting circuit that drives high-density light-emitting units. Additionally, in a laser according to an embodiment of the present disclosure, each light-emitting unit is provided with one wiring unit, enabling more light-emitting points to be arranged in the light-emitting unit and reducing the number of wiring units, resulting in fewer connecting wires, thereby not tending to block the light emission from the light-emitting units, and improving the light-emitting efficiency of the light-emitting units.

### BRIEF DESCRIPTION OF THE DRAWINGS

The drawings constituting a part of the present disclosure are used to provide a further understanding of the present disclosure. The schematic embodiments and descriptions of the present disclosure are used to explain the present disclosure, and do not constitute improper limitations to the present disclosure. In the drawings:
FIG. 1 illustrates a typical VCSEL;
FIG. 2 illustrates a typical laser driving circuit;
FIG. 3 illustrates a top view of a laser according to an embodiment of the present disclosure;
FIG. 4 illustrates a cross-sectional view of the laser of FIG. 3;
FIG. 5 illustrates a plan view of a light-emitting unit according to an embodiment of the present disclosure;
FIG. 6 illustrates a LiDAR according to an embodiment of the present disclosure;
FIG. 7 schematically illustrates an arrangement of emitting units and receiving units according to an embodiment of the present disclosure;
FIG. 8 illustrates an arrangement of the lasers in an emitting unit according to an embodiment of the present disclosure;
FIGS. 9A and 9B illustrate a comparative view between emitting units according to the embodiment of the present disclosure and existing emitting units;
FIGS. 10A and 10B illustrate two arrangements of the lasers according to an embodiment of the present disclosure;
FIG. 11 illustrates a driving circuit of the emitting units according to an embodiment of the present disclosure; and
FIG. 12 illustrates a schematic diagram of the driving circuit according to an embodiment of the present disclosure.

### DETAILED DESCRIPTION OF THE EMBODIMENTS

In the following, only some exemplary embodiments are briefly described. As a person skilled in the art can realize, the described embodiments may be modified in various different ways without departing from the spirit or scope of the present disclosure. Accordingly, the drawings and descriptions are to be regarded as illustrative and not restrictive in nature.

In the description of the present disclosure, it needs to be understood that the orientation or position relations denoted by such terms as "central" "longitudinal" "latitudinal" "length" "width" "thickness" "above" "below" "front" "rear" "left" "right" "vertical" "horizontal" "top" "bottom" "inside" "outside" "clockwise" "counterclockwise" and the like are based on the orientation or position relations as shown in the drawings, and are used only for the purpose of facilitating description of the present disclosure and simplification of the description, instead of indicating or suggesting that the denoted devices or elements must be oriented specifically, or configured or operated in a specific orientation. Thus, such terms should not be construed to limit the present disclosure. In addition, such terms as "first" and "second" are only used for the purpose of description, rather than indicating or suggesting relative importance or implicitly indicating the number of the denoted technical features. Accordingly, features defined with "first" and "second" may, expressly or implicitly, include one or more of the features. In the description of the present disclosure, "plurality" means two or more, unless otherwise defined explicitly and specifically.

In the description of the present disclosure, it needs to be noted that, unless otherwise specified and defined explicitly, such terms as "installation" "coupling" and "connection" should be broadly understood as, for example, fixed connection, detachable connection, or integral connection; or mechanical connection, electrical connection or intercommunication; or direct connection, or indirect connection via an intermediary medium; or internal communication between two elements or interaction between two elements. For those skilled in the art, the specific meanings of such terms herein can be construed in light of the specific circumstances.

Herein, unless otherwise specified and defined explicitly, if a first feature is "on" or "beneath" a second feature, this may cover direct contact between the first and second features, or contact via another feature therebetween, other than the direct contact. Furthermore, if a first feature is "on", "above", or "over" a second feature, this may cover the case that the first feature is right above or obliquely above the second feature, or just indicate that the level of the first feature is higher than that of the second feature. If a first feature is "beneath", "below", or "under" a second feature, this may cover the case that the first feature is right below or obliquely below the second feature, or just indicate that the level of the first feature is lower than that of the second feature.

The following disclosure provides various different embodiments or examples so as to realize different structures described herein. In order to simplify the disclosure herein, the following will give the description of the parts and arrangements embodied in specific examples. Of course, they are only for the exemplary purpose, not intended to limit the present disclosure. Besides, the present disclosure may repeat a reference number and/or reference letter in different examples, and such repeat is for the purpose of simplification and clarity, which does not represent any relation among various embodiments and/or arrangements as discussed. In addition, the present disclosure provides examples of various specific processes and materials, but those skilled in the art can also be aware of application of other processes and/or use of other materials.

The preferred embodiments of the present disclosure will be described below with reference to the drawings. It should be appreciated that the preferred embodiments described here are only for the purpose of illustrating and explaining, instead of limiting, the present disclosure.

In order to improve the light-emitting density of a laser without significantly increasing its area, thereby improving the vertical angular resolution and point cloud density of the LiDAR when it is for use in a LiDAR, the present disclosure provides a laser comprising a plurality of light-emitting units, each light-emitting unit comprising a plurality of light-emitting points, the plurality of light-emitting units sharing a cathode or an anode, each light-emitting unit respectively provided with a wiring unit, and each wiring unit being electrically connected to an unshared anode or cathode of its corresponding light-emitting unit. By this means, a significant increase in the number of light-emitting units can be achieved with the same size, thereby improving the vertical angular resolution and point cloud density of the LiDAR.

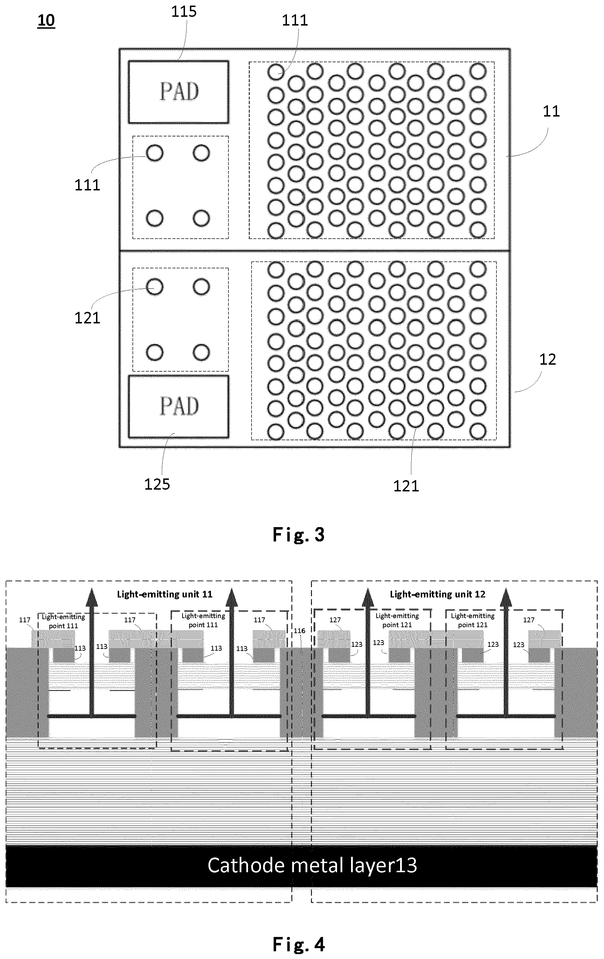

FIG. 3 illustrates a top view of a laser according to one embodiment of the present disclosure, and FIG. 4 illustrates a cross-sectional view of the laser of FIG. 3. Then a specific structure of the laser will be described below in detail with reference to FIGS. 3 and 4.

As shown in FIG. 3, the laser 10 comprises light-emitting units 11 and 12, each light-emitting unit comprising a plurality of light-emitting points, as exemplified by the circular light-emitting points 111 and 121 in FIG. 3. The light-emitting units 11 and 12 can be light-emitting units of the same type, for example, VCSEL light-emitting units having a plurality of light-emitting points. FIG. 3 schematically illustrates that the laser 10 comprises two light-emitting units 11 and 12. However, the present disclosure is not limited to this, and the laser 10 can also comprise three or more light-emitting units. For clarity, the following description is carried out by taking the two light-emitting units 11 and 12 as an example.

Preferably, when the laser 10 is for use in a LiDAR, the plurality of light-emitting points of the light-emitting units 11 and 12 can be grouped in order to give consideration to both the measurement of close-range object and the measurement of long-range object simultaneously. As shown in FIG. 3, for the plurality of light-emitting points 111 of the light-emitting unit 11, the densely arranged light-emitting points 111 on the right side (framed out by dashed lines) are used for detecting long-range object at a distant distance, while the sparser arranged and fewer light-emitting points 111 on the left side (framed out by dashed lines) are used for detecting close-range object at short distance. Alternatively, the light-emitting points 111 on the left side can also be arranged in a dense way similar to those on the right side. The same way also applies to the plurality of light-emitting points 121 of the light-emitting unit 12.

FIG. 4 provides a clearer illustration of the internal structure of the laser 10. As shown in FIG. 4, the light-emitting units 11 and 12 share a cathode, that is, the cathode of the light-emitting units 11 and 12 is implemented through one and the same cathode metal layer 13 (or alternatively, the respective cathodes of the light-emitting units 11 and 12 are electrically connected together through a metal layer), while the unshared anodes of the light-emitting units 11 and 12 are separated from each other. For the light-emitting unit 11, an anode 113 is, for example, a ring-shaped metal electrode arranged around each light-emitting point 111, with a central opening serving as a light-emitting pathway for emitting laser light (as indicated by an arrows in FIG. 4). When a driving voltage is applied between the cathode metal layer 13 and the anode 113, the light-emitting point 111 of the light-emitting unit 11 will emit laser light. Similarly, for the light-emitting unit 12, an anode 123 thereof can also be a ring-shaped metal electrode arranged around each light-emitting point 121, with a central opening for emitting laser light.

As shown in FIG. 3, each light-emitting unit further comprises a wiring unit. For example, the light-emitting units 11 and 12 each comprise wiring units 115 and 125 respectively, the wiring unit 115 being electrically connected to the unshared anode 113 of the light-emitting unit 11, and the wiring unit 125 being electrically connected to the unshared anode 123 of the light-emitting unit 12. For each light-emitting unit 11, the cathode metal layer 13 thereof is grounded, for example, through a switching device, and the wiring unit 115 is used for connecting to a driving voltage source, thereby driving each light-emitting point of the light-emitting unit 11 to emit laser beams. The wiring unit can be in the form of a wiring pad, for example.

Additionally, according to one preferred embodiment of the present disclosure, between adjacent light-emitting units, the unshared anodes or cathodes are separated by an insulation layer. As shown in FIG. 4, the light-emitting units 11 and 12 share a cathode, while the anodes are not shared; and between the light-emitting units 11 and 12, the anodes 113 and 123 thereof are separated by an insulation layer 116 to achieve individual control and driving.

In the embodiments of FIGS. 3 and 4, illustrated is an example of the plurality of light-emitting units sharing a cathode while not sharing an anode. However, the present disclosure is not limited to this, which can also be implemented in a mode where the plurality of light-emitting units share an anode while not sharing a cathode. These all fall within the scope of protection of the present disclosure.

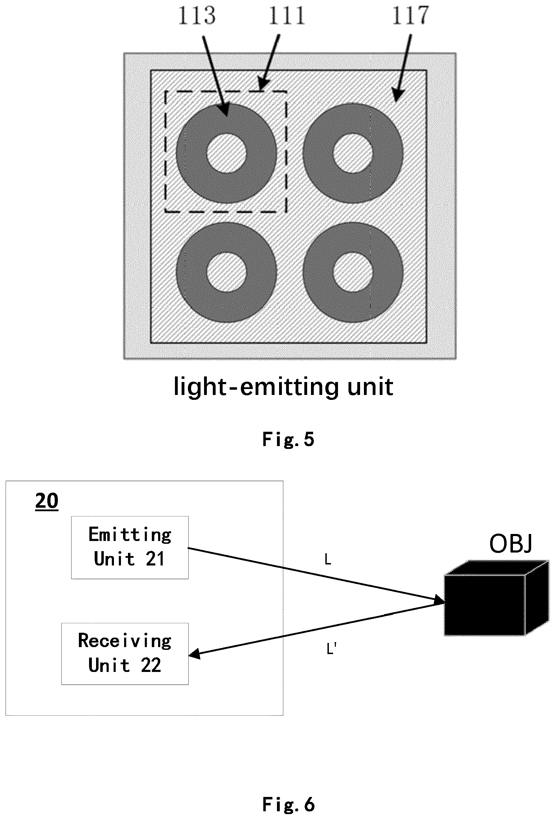

According to one preferred embodiment of the present disclosure, a second metal layer is further included within each light-emitting unit, which covers an unshared anode or cathode of the light-emitting unit, and is provided with an opening corresponding to each light-emitting point. FIG. 5 illustrates a plan view of the light-emitting unit 11. As shown in FIGS. 4 and 5, the light-emitting unit 11 comprises a second metal layer 117 covering the anode 113 of the light-emitting unit 11, for example. The second metal layer 117 can be an integral metal layer provided thereon with an opening corresponding to each light-emitting point (as shown in the blank part in FIG. 5), and serving as a light transmission path for a laser beam emitted by each light-emitting point. Between the light-emitting units 11 and 12, the second metal layers 117 and 127 thereof are separated from each other to achieve individual control and driving. According to one embodiment of the present disclosure, the wiring unit 115 can be formed as a portion of the second metal layer 117, or can be formed as a wiring pad disposed on the second metal layer 117.

The specific number of light-emitting units is not limited according to the present disclosure, but the laser 10 preferably comprises two light-emitting units 11 and 12, the two light-emitting units sharing a cathode, and each light-emitting unit comprising one wiring unit.

According to an embodiment of the present disclosure, the plurality of light-emitting units included in the laser 10 can be driven to emit light simultaneously or successively. When the plurality of light-emitting units are driven to emit light successively, the wiring units of the plurality of light-emitting units are connected to different voltage sources; when the plurality of light-emitting units are driven to emit light simultaneously, the wiring units of the plurality of light-emitting units are connected to the same voltage source or different voltage sources.

Described above is a laser comprising a plurality of light-emitting units, each light-emitting unit provided with one wiring unit (PAD) that is, for example, an anode pad and is connected to a power source HV through metal wire-bonding, and the plurality of light-emitting units sharing a cathode pad, thereby allowing the overall footprint of the laser remains unchanged. Since each light-emitting unit is only provided with one wiring unit, enabling more light-emitting points to be arranged in the light-emitting unit and reducing the number of wiring units, resulting in fewer connecting wires, thereby not tending to blocking the light emission from the light-emitting units, and improving the light-emitting efficiency of the light-emitting units.

FIG. 6 illustrates a LiDAR 20 according to one embodiment of the present disclosure. The LiDAR 20 comprises an emitting unit 21 and a receiving unit 22. Among them, the emitting unit 21 comprises a plurality of lasers 10 as described above, each laser comprising a plurality of light-emitting units configured to emit a detection light beam L, each light-emitting unit comprising a plurality of light-emitting points, wherein the plurality of light-emitting units share a cathode or an anode; and each light-emitting unit is respectively provided with a wiring unit; and each wiring unit is electrically connected to an unshared anode or cathode of its corresponding light-emitting unit. The receiving unit 22 comprises a plurality of detectors configured to receive an echo light beam L' of the detection light beam L after being reflected of an object OBJ, and convert the echo light beam L' into an electrical signal.

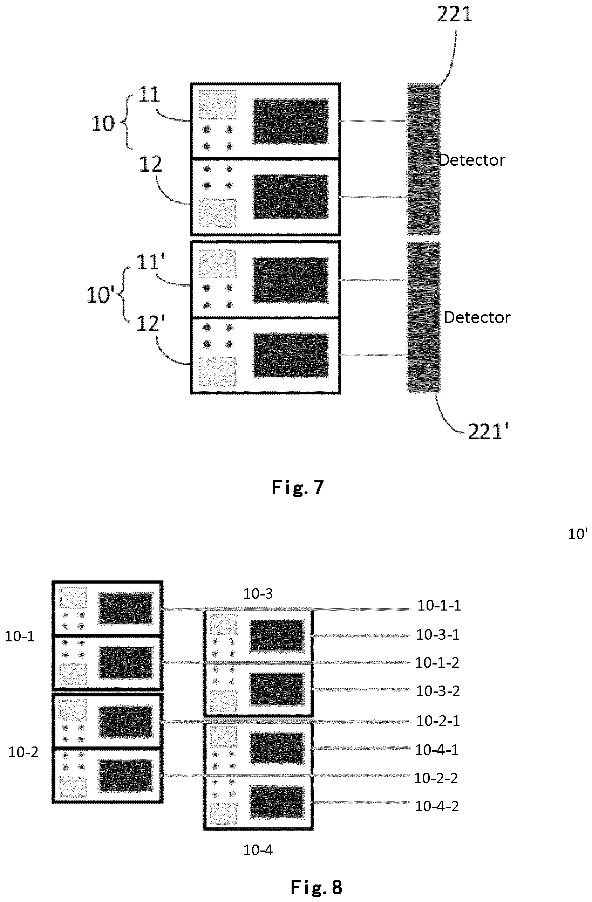

According to one preferred embodiment of the present disclosure, the emitting unit 21 and the receiving unit 22 of the LiDAR 20 form a plurality of detection channels, each detection channel comprising one light-emitting unit 11 or 12 and one corresponding detector 221. As shown in FIG. 7, the emitting unit 21 is schematically illustrated to comprise the laser 10 and a laser 10', wherein the laser 10 corresponds to the detector 221 while the laser 10' corresponds to the detector 221', that is, two light-emitting units 11 and 12 correspond to the detector 221 to form two detection channels respectively; and likewise, two light-emitting units 11' and 12' correspond to the detector 221' to also form two detection channels respectively. As shown in FIG.7, the laser 10 comprises two light-emitting units 11 and 12, and the laser 10' comprises two light-emitting units 11' and 12', wherein the echo light beams generated from the detection light beams emitted by the two light-emitting units of each laser are received by the same detector, for example, the echo light beams generated from the detection light beams emitted by the light-emitting units 11' and 12' are received by the detector 221'. The same principle applies to a larger number of detection channels as well, which will not be repeated here. Additionally, FIG. 7 is provided only for representing the correspondence between a laser and a detector, which does not show their actual positions.

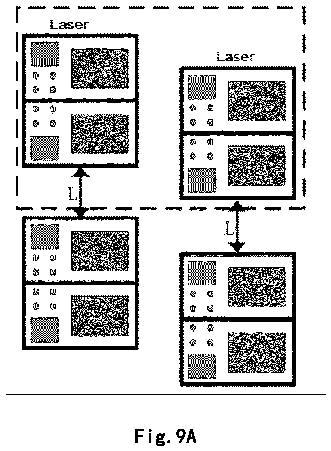

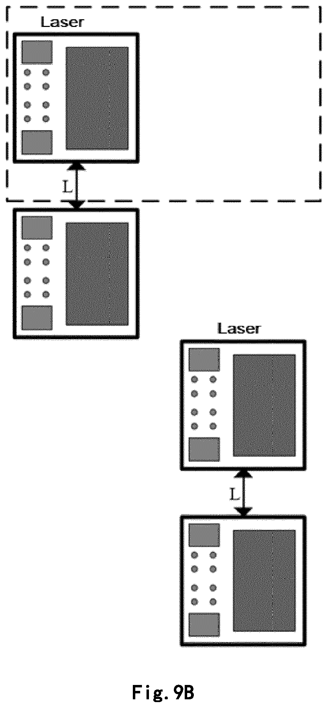

In FIG. 7, the lasers 10 and 10' are arranged in a column. However, it can also be conceived that a plurality of lasers are arranged in multiple columns along a vertical direction. As shown in FIG. 8, the multiple columns of lasers are staggered from each other, such that the principal light directions of the detection light beams emitted by each light-emitting unit in the plurality of lasers are staggered from each other. As shown in FIG. 8, lasers 10-1 and 10-2 are arranged in a column, while lasers 10-3 and 10-4 are arranged in another column. Each laser, for example, comprises two light-emitting units, each light-emitting unit emitting detection light beams respectively, the principal light directions of the detection light beams emitted by each light-emitting unit are preferably staggered from each other to avoid overlapping. In the present disclosure, the principal light direction of a detection light beam refers to the direction of a center light ray of the detection light beam, which is the direction perpendicular to the paper surface in FIG. 8. Those skilled in the art can readily understand that in FIG. 8, lines 10-1-1 and 10-1-2 are used to indicate the vertical positions of the principal light directions of the detection light beams of the two light-emitting units of the laser 10-1 in the figure, lines 10-2-1 and 10-2-2 are used to indicate the vertical positions of the principal light directions of the detection light beams of the two light-emitting units of the laser 10-2 in the figure, lines 10-3-1 and 10-3-2 are used to indicate the vertical positions of the principal light directions of the detection light beams of the two light-emitting units of the laser 10-3 in the figure, and lines 10-4-1 and 10-4-2 are used to indicate the vertical positions of the principal light directions of the detection light beams of the two light-emitting units of the laser 10-4 in the figure. According to the vertical position of the principal light direction of the detection light beam of each light-emitting unit in FIG. 8, the principal light directions of the detection light beams are staggered in the vertical direction. The same situation occurs in FIGS. 9A and 9B below.

By adopting the layout shown in FIG. 8, two columns of lasers are arranged in a staggered manner, which can significantly increase the vertical angular resolution of the LiDAR. The detailed explanation will be made below with reference to FIGS. 9A and 9B.

FIG. 9A corresponds to the laser layout in FIG. 8, while FIG. 9B corresponds to the laser layout in an existing LiDAR. A vertical angular resolution can be represented as arctan (L/H), where L is a spacing between lasers along a vertical direction, H is a focal length, and the dashed frames in FIGS. 9A and 9B have the same area. For a typical arrangement of a plurality of lasers as shown in FIG. 9B, when a spacing between lasers is L and a focal length is f, a vertical resolution in the area of the dashed frame is arctan (L/f); while as shown in FIG. 9A, each laser has two light-emitting units, and two columns of lasers are arranged in a staggered manner, such that the number of light-emitting units in the same area increases from 1 to 4, and a vertical resolution thereof is arctan (L/4f), thereby producing a fourfold increase in resolution. The figure only shows two columns with a total of 4 lasers arranged in a staggered manner, and there can also be N lasers arranged in a staggered manner in each column, or three, four, or more columns of lasers can further be arranged in a staggered manner. A single laser can also comprise three or more light-emitting units sharing a cathode (or anode) along the vertical direction, corresponding to one detector, which will further increase the vertical resolution, and effectively solve the problem of difficulty in increasing the vertical resolution due to the limited density of detector devices. Preferably, the vertical angular resolution of the LiDAR is less than 0.4°.

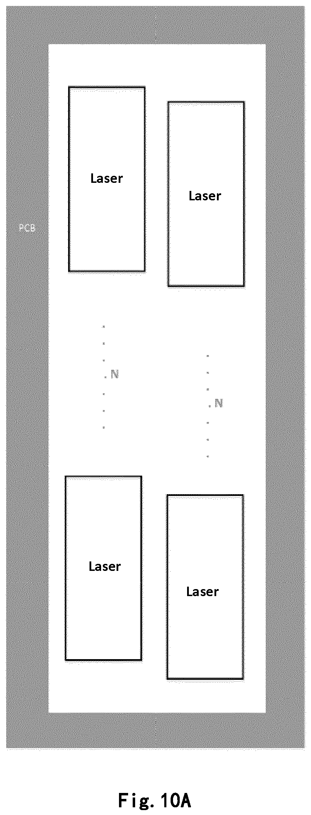

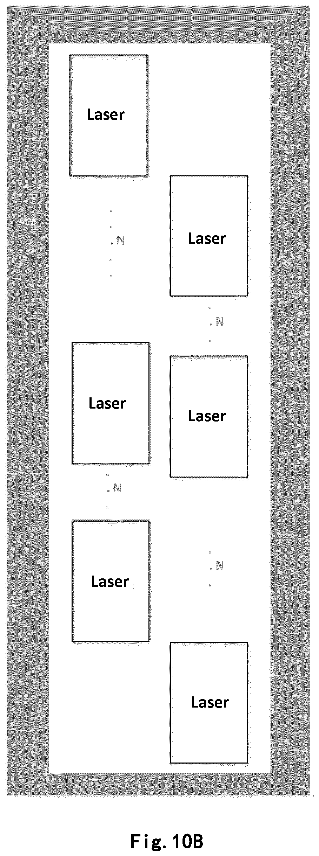

FIGS. 10A and 10B illustrate two arrangements of the lasers according to an embodiment of the present disclosure. In FIG. 10A, two columns of lasers are overall staggered from each other along a vertical direction, with N lasers (linearly arranged in a vertical direction) in each column, and the two columns of lasers all staggered left and right to enhance the density. Alternatively, as shown in FIG. 10B, two columns of lasers are arranged in a staggered manner along a vertical direction, with N lasers (linearly arranged along a vertical direction) in each column, and some of the lasers staggered left and right to enhance the density. For example, the density of the lasers in the middle region is enhanced while the density of lasers close to the upper and lower ends remains unchanged.

According to an embodiment of the present disclosure, the plurality of light-emitting units included in the laser 10 can be driven to emit light simultaneously or successively. When the plurality of light-emitting units are driven to emit light successively, the wiring units of the plurality of light-emitting units are connected to different voltage sources; when the plurality of light-emitting units are driven to emit light simultaneously, the wiring units of the plurality of light-emitting units are connected to the same voltage source or different voltage sources.

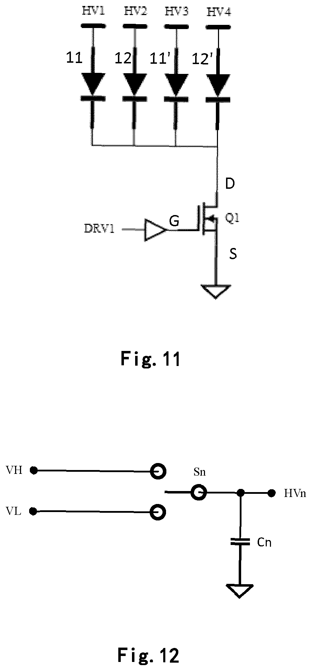

In order to drive the lasers to emit detection light beams, the emitting unit 21 also comprises a driving circuit configured to provide different driving voltages to the plurality of light-emitting units of the lasers. The driving circuit can be implemented, for example, by means of allowing a plurality of light-emitting units to be driven by different driving voltages through a shared switching device, and the driving circuit provides driving voltages HV1, HV2, HV3, and HV4. Referring to the description of FIG. 11, four light-emitting units are shown therein, for example, the light-emitting units 11, 12, 11' and 12' in FIG. 7, among which the light-emitting units 11 and 12 belong to the laser 10, and the light-emitting units 11' and 12' belong to the laser 10'. As shown in FIG. 11, the lasers 10 and 10' adopt the connection way of sharing a cathode, with the wiring unit of each light-emitting unit connected to any of HV1-HV4, respectively. For example, the wiring unit of the light-emitting unit 11 in the laser 10 is connected to HV1, and the wiring unit of the light-emitting unit 12 is connected to HV2; and the wiring unit of the light-emitting unit 11' in the laser 10' is connected to HV3, and the wiring unit of the light-emitting unit 12' is connected to HV4. The light-emitting units of other lasers can be connected to HV1, HV2, HV3, and HV4 respectively.

The emitting unit 21 further comprises a switching device Q1. The switching device Q1 can be a GaN switch, or an NMOS transistor. Taking an NMOS transistor as an example, the switching device Q1 comprises a first terminal (drain D) electrically connected to a shared cathode of each of the lasers, a second terminal (source S) being grounded, and a control terminal (gate G) that can control the ON and OFF of the switching device according to a driving signal DRV1. When the switching device Q1 is ON, a circuit loop is formed for the light-emitting units 11, 12, 11', and 12' of the lasers 10 and 10', such that the driving voltages HV1, HV2, HV3, and HV4 drive the corresponding light-emitting units to emit detection light beams.

FIG. 12 illustrates the process of establishing one of the driving voltages HVn in the driving circuit, wherein VH is a driving voltage required for light emission by a light-emitting unit, and VL is the zero potential or a lower potential at which the light-emitting unit does not emit light. Usually, VH and VL are voltage-stabilized sources generated from a switching power supply, and a switch Sn can be a switch device or a multiplexer MUX. At first, a HV switching circuit is controlled, a HV1 switching switch is connected to VH while HV2, HV3, and HV4 switching switches are connected to VL, the power supply VH charges a capacitor C1, and the switch Sn is OFF after a period of time; next, the controller controls a switch driver (DRV1) to emit driving pulses to turn on the switch Q1, a discharge loop is formed between the capacitor C1 and the light-emitting unit 11, the switch Q1 and the ground, and then the light-emitting unit 11 emits light. By adopting the driving circuit shown in FIGs. 11 and 12, the number of switching devices can be reduced while the PCB footprint is decreased.

The specific connections of the driving circuits shown in FIGS. 11 and 12 can be adjusted according to actual situations. For example, with regard to the light-emitting units 11 and 12, if the light-emitting units 11 and 12 are controlled to emit light simultaneously, they can be connected to HV1 simultaneously; or the light-emitting unit 11 can be connected to HV1 while the light-emitting unit 12 to HV2, and then the switching device Q1 is turned ON, and the switches S1 and S2 are controlled to switch to VH, and the switches S3 and S4 are controlled to switch to VL, such that the light-emitting units 11 and 12 emit light simultaneously. When the light-emitting units 11 and 12 are controlled to emit light successively, the light-emitting unit 11 can be connected to HV1 while the light-emitting unit 12 can be connected to HV2, then the switch S1 switches from VL to VH, and the switching device Q1 is turned ON to cause the light-emitting unit 11 to emit light; afterwards, the switch S2 switches from VL to VH while the switch S1 switches from VH to VL, and the switching device Q1 is turned ON to cause the light-emitting unit 12 to emit light, thereby achieving successive light emission of the light-emitting units 11 and 12.

By controlling the establishment of the driving voltages HV1, HV2, HV3, and HV4, as well as controlling ON and OFF of the switching device Q1, the light-emitting units of each laser can be driven in sequence to emit detection light beams. Preferably, two or more light-emitting units within one laser emit detection light beams successively.

The LiDAR described above comprises a laser provided with a plurality of light-emitting units. The area of the laser provided with a plurality of light-emitting units does not increase, and echo light beams generated from detection light beams emitted by the plurality of light-emitting units are received by the same detector, thereby improving the vertical angular resolution and point cloud density of a LiDAR. Meanwhile, the number of light-emitting units is doubled in the same area, allowing the plurality of light-emitting units driven by different driving voltages in a driving circuit to share a switching device, thereby saving the switching devices and the driving thereof, reducing the costs, and realizing an emitting circuit that drives high-density light-emitting units.

Last but not least, it is noted that described above are just preferred embodiments of the present disclosure, which are not used to limit the present disclosure. Although the detailed description of the present disclosure has been provided with reference to the foregoing embodiments, those skilled in the art can still make modifications to the technical solution as recited in each of the foregoing embodiments, or conduct equivalent replacement of some technical features therein. Any modification, equivalent replacement, or improvement, if falling into the spirit and principles as stated herein, should be included in the scope of protection of the present disclosure.

## Claims

1. A laser for use in a LiDAR, comprising: a plurality of light-emitting units, each light-emitting unit comprising a plurality of light-emitting points, wherein the plurality of light-emitting units share a cathode or an anode, each light-emitting unit is respectively provided with a wiring unit, and each wiring unit is electrically connected to an unshared anode or cathode of its corresponding light-emitting unit.

2. The laser according to claim 1, wherein the unshared anodes or cathodes of the plurality of light-emitting units are separated by an insulation layer, and the shared cathodes or anodes are connected by a first metal layer.

3. The laser according to claim 1, wherein the plurality of light-emitting units are configured to be driven to emit light simultaneously or successively.

4. The laser according to claim 3, wherein the wiring units of the plurality of light-emitting units are connected to different voltage sources when the plurality of light-emitting units are driven to emit light successively.

5. The laser according to claim 3, wherein the wiring units of the plurality of light-emitting units are connected to the same voltage source or different voltage sources when the plurality of light-emitting units are driven to emit light simultaneously.

6. The laser according to claim 1, wherein the laser comprises two light-emitting units sharing a cathode, and each light-emitting unit comprising one wiring unit.

7. The laser according to claim 1, wherein each light-emitting unit further comprises a second metal layer covering the unshared anodes or cathodes of the light-emitting units, and provided with an opening for light emission of each light-emitting point.

8. The laser according to claim 7, wherein the wiring unit is a portion of the second metal layer, or a wiring pad disposed on the second metal layer.

9. A LiDAR, comprising:
an emitting unit, comprising a plurality of lasers according to any one of claims 1-8, wherein each laser comprises a plurality of light-emitting units configured to emit detection light beams, each light-emitting unit comprising a plurality of light-emitting points, wherein the plurality of light-emitting units share a cathode or an anode, and each light-emitting unit is respectively provided with a wiring unit, and each wiring unit is electrically connected to an unshared anode or cathode of its corresponding light-emitting unit; and
a receiving unit, comprising a plurality of detectors configured to receive echo light beams of the detection light beams after being reflected off an object, and to convert the echo light beams into electrical signals.

10. The LiDAR according to claim 9, wherein the emitting unit and the receiving unit of the LiDAR form a plurality of detection channels, each detection channel comprising one light-emitting unit and one corresponding detector.

11. The LiDAR according to claim 9 or 10, wherein the echo light beams generated from detection light beams emitted by the plurality of light-emitting units of the same laser are received by the same detector.

12. The LiDAR according to claim 9 or 10, wherein the plurality of lasers are arranged in multiple columns along a vertical direction, the multiple columns of lasers being staggered from each other, such that principal light directions of the detection light beams emitted by each light-emitting unit in the plurality of lasers are staggered from each other.

13. The LiDAR according to claim 12, wherein the multiple columns of lasers are overall staggered from each other along the vertical direction, or only a middle portion of each column of lasers staggered from each other.

14. The LiDAR according to claim 13, wherein a vertical angular resolution of the LiDAR is less than 0.4°.

15. The LiDAR according to claim 9 or 10, wherein the emitting unit further comprises a driving circuit configured to provide different driving voltages to the plurality of light-emitting units of the lasers.

16. The LiDAR according to claim 15, wherein the emitting unit further comprises a switching device comprising a first terminal electrically connected to the shared cathode or anode of the light-emitting units, a second terminal being grounded, and a control terminal that can control ON and OFF of the switching device according to a driving signal.

17. The LiDAR according to claim 9 or 10, wherein the emitting unit is configured to drive each light-emitting unit in sequence to emit detection light beams.
